# EUROPEAN PATENT APPLICATION

(11) **EP 1 107 105 A1**
(43) Date of publication of application: **13.06.2001**
(21) Application number: 99309981.1
(22) Date of filing: 10.12.1999
(51) Int. Cl.: G06F 5/00, H03M 7/00

(54) **Extending the data word length for data transmission and data processing**

(71) Applicant: LUCENT TECHNOLOGIES INC., Murray Hill, New Jersey 07974-0636 (US)
(72) Inventor: Lehnert, Martin, Erlangen 91058 (DE)
(74) Representative: Williams, David John

(57) **Abstract**

The invention relates to a method for expanding a first, N-digit data word in two's complement representation to produce a second, (N+M)-digit data word for data transmission and data processing, and to an apparatus for carrying out the method.

To provide a method which imposes no increased hardware requirements on an apparatus for carrying out the method and which prevents numerical-range overflows when the converted number is negated, the invention proposes putting the digits of the original number into the more significant places of the target binary number, retaining the order of digits, and entering the digit "1" at least once into the first M-places of the second binary number.

## Description

The invention relates to a method for extending the data word length of any desired first, N-digit data word to form a second, (N+M)-digit data word for data transmission and data processing, and to an apparatus for carrying out the method.

In the field of IT, data processing and data transmission are essentially digital processes. Associated digital circuits or processing programs process binary information, that is to say information having two values. Particularly when carrying out computational operations, the two's complement representation of the respective binary number has been found to be extremely advantageous, because, with such representation, subtraction can easily be traced back to addition of the two's complement of the number. With this two's complement representation, the MSB (Most Significant Bit) denotes a sign bit, the relevant digit value being assessed as negative.

In electronic circuits, a multiplicity of hardware components, for example shift registers, code converters, multiplexers or adders, frequently have a different number of digit. Consequently, during data transmission and/or data processing of binary numbers in two's complement representation, it is frequently a problem that an N-digit binary number has to be converted into an (N+M)-digit binary number in order to make it available to further electronic circuits, for example for computational operations. When the more significant places of the original number are expanded by inserting the digit "0", negative values must first be transferred to the correct two's complement again. A widespread solution based on the prior art involves storing the source value, i.e. the first binary number, in the less significant places and extending the sign bit. This method is called sign extension, cf. "Halbleiterschaltungstechnik [Semiconductor Circuit Technology]", U. Tietze and Schenk, Springer, 1999, page 660, for example. Sign extension ensures that the value of the binary number is not changed by conversion. In addition, it ensures that conversion produces a numerical range in which no numerical-range overflow can occur as a result of negation. A disadvantage, however, is that the conversion described requires an active procedure, i.e. determination of the sign bit, which results in greater hardware complexity for the associated apparatus for converting the binary numbers.

It is therefore the object of the invention to provide a data word expansion method for expanding a first, N-digit data word to produce a second, (N+M)-digit data word without implementation of the method entailing increased hardware requirements and without there being the possibility of numerical-range overflows occurring when the converted number is negated.

This object is achieved simply by a data word expansion method for expanding a first, N-digit binary number to produce a second, (N+M)-digit data word having the features of Claim 1 and with an apparatus for carrying out the method according to Claim 4. Advantageous embodiments of the invention are specified in the subclaims.

In order, firstly, to prevent an active procedure in the shape of recognition of at least one digit in the first data word, i.e. in the source binary number, and to ensure symmetry of the second data word, i.e. of the target binary number, with respect to the "0", the invention proposes putting the digits of the source binary number into the most significant places of the target binary number, and entering the digit "1" at least once into the first M-places of the target binary number. This procedure is easy to implement in terms of circuitry, for example, irrespective of the target binary number, so that there is no need for detection of any digit in the number which is to be converted. Putting the digit "1" into at least one of the first M-places ensures that the largest negative number possible, in principle, on the basis of the number of places is not reached, and consequently no numerical-range overflow can occur on negation, i.e. the converted data words are symmetrical around zero.

As will be seen by a person skilled in the art, conversion of the N-digit binary number to produce an (N+M)-digit binary number is equivalent, in terms of circuitry, to extending the data word length, for example of a data channel for data transmission.

The method according to the invention can, in principle, be used both for an appropriate hardware circuit and also with a software solution.

It should be taken into account that the addition of a "1", which is usual for two's complement representation, when calculating the two's complement after calculating the one's complement "is inconsequential", since this "1" is added on in the least significant place. This is also relevant, in particular, if the most significant of the M places is occupied by "0", so that, on negation, the N digits taken over from the source word are not affected by the extension of the data word length. The error which this causes is not very critical for example, for data transmission or data processing of binary numbers from analogue/digital converter devices, however, because the least significant bit (LSB) of a binary number representing a converted analogue value generally represents the conversion error and is therefore indeterminate. However, the error produced by the method according to the invention corresponds to the LSB, so that this error can still be tolerated, particularly in the field of application described. It will generally be found that the least significant place represents the deviation from the source value, which produces no critical inaccuracy in the result, particularly for (M+N) >> N.

It should be pointed out that the (M+N)-digit binary number needs to be converted back into a representation corresponding to the actual value of the binary number after data transmission or data processing; this conversion is easily understood and can be carried out by a person skilled in the art, however, and it is therefore not discussed below.

With certain restrictions, the first M-places of the target data word can, in principle, be stipulated as desired, with the exception that there must be at least one "1" as a digit within the first M-places. In one embodiment of the invention, the first M-places have only a single digit "1" in total, and this is put in the place of the LSB, while the other places are occupied by the digit "0". This conversion rule for converting the N-digit binary number in two's complement representation into a second, (N+M)-digit binary number has the advantage that the digit value added to the first binary number is small and is therefore frequently negligible.

In addition, the invention can also provide for the Mth place of the second data word to be set to "0".

The invention is explained below with a description of one embodiment on the basis of the drawings, in which
- Figure 1: shows a basic sketch of an apparatus for carrying out the method according to the invention, and
- Figure 2: shows conversion of the binary number having the decimal value "-78", as carried out using this apparatus.

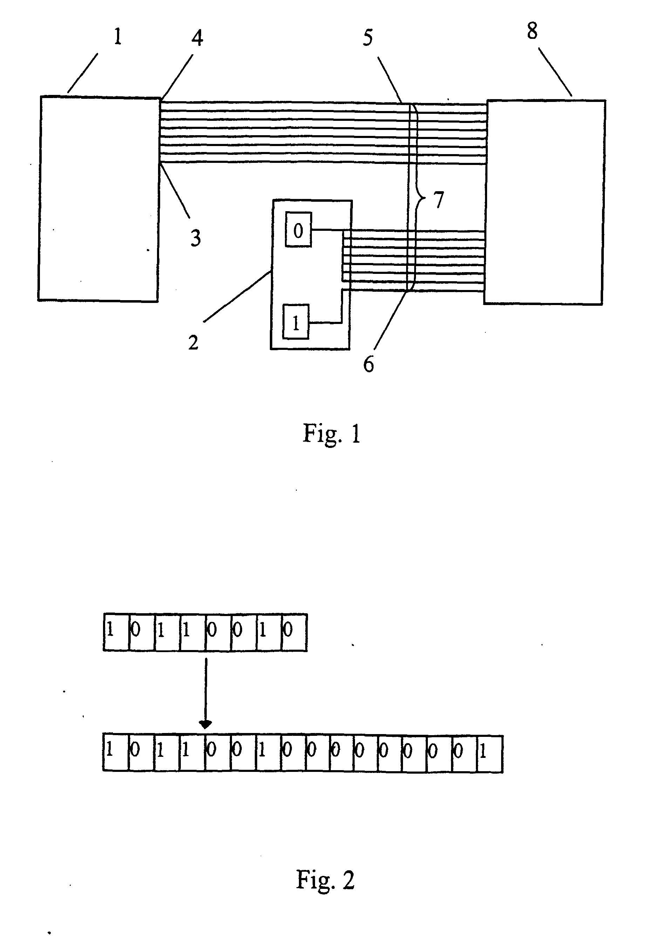

Figure 1 shows a basic sketch of an apparatus for carrying out a method according to the invention for extending the data word length of an eight-digit binary number in two's complement representation to produce a second, sixteen-digit binary number. For this, an 8-bit storage register 1 is connected to a 16-bit data channel 7. Each of the 8 storage cells of the storage register 1 is hard-wired to an associated bit position of the 16-bit data channel 7. This association is such that the 8-bit word from the source, i.e. from the storage register 1, is in the more significant bit positions of the 16-bit data channel, i.e. the storage cell for the first bit 3 of the storage register 1 is connected to the ninth bit position of the data channel 7, and the storage cell for the eighth bit of the storage register 1 is coupled to the sixteenth bit position of the data channel 7.

By means of hard-wiring as shown in Figure 1, the first 8 bit positions of the 16-bit data channel are stipulated using a circuit device 2 such that the first bit position 6 receives the value "1", and the bit positions 2 to 8 receive the value "0". Depending on the embodiment of the invention, the aforementioned hard-wiring in the circuit device 2 used to stipulate the first 8 bit positions of the 16-bit data channel, i.e. the first byte of the second binary number, can vary. By way of example, it is also possible for all 8 bits to receive the value "1".

As shown in Figure 1, the (N+M)-line data channel has a third circuit device 8 connected to it, which can perform subsequent data processing only with 16-bit data words, which is the reason why the method according to the invention is used on the first data word in the first circuit device 1.

A person skilled in the art will understand that data word expansion according to the invention can also be implemented in an integrated circuit, for example, when two interconnected integrated circuit modules process data words of different lengths and the data channel, for example a data bus between the two modules, therefore has to be matched.

Figure 2 shows data word expansion, carried out using the apparatus shown in Figure 1, of the data word in two's complement representation having the decimal value "-78" to produce the associated sixteen-digit binary number.

In another embodiment of the invention, extension of the data word length for any desired N-digit binary number in two's complement representation to produce an associated (N+M)-digit binary number is implemented using a shift register, the N-digit binary number being shifted M times by 1 bit in each case, and the less significant places being set to predetermined digits by means of hard-wiring, with at least one "1" being included.

## Claims

1. Data word expansion method for expanding a first, N-digit data word in two's complement representation to produce a second, (N+M)-digit data word, where N and M are natural numbers greater than 0, characterized in that the digits in the second data word are stipulated as follows:
the digits in the Nth to 1st place (4, 3) of the first data word are put into the (N+M)th to (M+1)th place of the second data word, retaining the order of digits, and at least one of the first M places of the second data word is set to the logic value "1".

2. Method according to Claim 1, characterized in that precisely one of the first M places of the second data word is set to the logic value "1".

3. Method according to Claim 1 or 2, characterized in that the logic value "0" is put into the Mth place of the second data word.

4. Method according to Claim 2 or 3, characterized in that the logic value "1" is put into the least significant place (6) of the second data word, and the logic value "0" is put into each of the subsequent places up to and including the Mth place.

5. Apparatus for extending the data word length from N to (N+M) digits, particularly for carrying out a method according to Claims 1 to 4, comprising
- a first circuit device (1) for outputting an N-digit data word in two's complement representation, the N-digit output of which is connected to the more significant places of an (N+M)-bit-wide data channel (7), retaining the order of places, and
- a second circuit device (2) designed for outputting a prescribed M-digit data word having at least one logic "1", the M-digit output of which is connected to the less significant M places of the (N+M)-bit-wide data channel.

6. Circuit arrangement having an apparatus for extending the data word length according to Claim 5 and a third circuit device (8), whose (N+M)-wide input is connected to the (N+M)-wide data channel (7).
